Europäisches Patentamt

European Patent Office

Office européen des brevets

(11) Numéro de publication: **0 397 574**
**A1**

## (12) DEMANDE DE BREVET EUROPEEN

(21) Numéro de dépôt: **90401246.5**

(22) Date de dépôt: **10.05.90**

(51) Int. Cl.⁵ **G01R 33/38**

(30) Priorité: **12.05.89 FR 8906284**

(43) Date de publication de la demande:
**14.11.90 Bulletin 90/46**

(84) Etats contractants désignés:
**DE GB NL**

(71) Demandeur: **COMMISSARIAT A L'ENERGIE ATOMIQUE**
**31/33, rue de la Fédération**
**F-75015 Paris(FR)**

(72) Inventeur: **Dufour, Michel**
**3 rue Pierre Sémard**
**F-38000 Grenoble(FR)**
Inventeur: **Jeandey, Christian**
**Chemin Fiancey, Le Muret**
**F-38120 Saint Egreve(FR)**

(74) Mandataire: **Mongrédien, André et al**
**c/o BREVATOME 25, rue de Ponthieu**
**F-75008 Paris(FR)**

(54) **Dispositif pour la production de champs magnétiques possédant une composante à gradient constant.**

㊀ Dispositif pour la production d'un champ magnétique possédant une composante à gradients constants composé d'un premier support (10) mince, isolant et amagnétique en forme de parallélépipède supportant sur l'une de ses faces une structure à quatre enroulements reliés en série principalement allongés selon l'axe ox d'un trièdre trirectangle de référence, sur l'autre de ses faces une structure à quatre enroulements reliés en série principalement allongés suivant l'axe oy et d'un second support (12) mince isolant et amagnétique, de forme parallélépipédique, supportant sur ses faces parallèles au plan xoy deux bobinages plats à spires rectangulaires reliés en série, les premier et second supports étant aptes à s'emboîter l'un dans l'autre.

Application à l'imagerie RMN.

FIG. 1

# DISPOSITIF POUR LA PRODUCTION DE CHAMPS MAGNETIQUES POSSEDANT UNE COMPOSANTE A GRADIENT CONSTANT

La présente invention a pour objet un dispositif pour la production de champs magnétiques possédant une composante à gradient constant. Elle s'applique notamment à l'imagerie par la méthode de résonance magnétique nucléaire (RMN) mais aussi à la spectroscopie RMN, aussi bien dans le domaine médical qu'industriel.

La méthode d'imagerie RMN utilise la propriété de résonance magnétique nucléaire de certains noyaux présents dans le corps humain, essentiellement les protons répartis dans tout l'organisme, et quelques noyaux d'intérêt biologique mais en abondance beaucoup moins grande tels que le phosphore ($^{31}P$), le potassium ($^{39}K$), le sodium ($^{23}Na$).

Une installation de RMN médicale se compose principalement d'un aimant destiné à produire dans toute la zone du corps à examiner un champ magnétique de polarisation $\overrightarrow{Bo}$ , statique et uniforme, auquel on superpose, à l'aide d'une bobine auxiliaire, un champ tournant de radio-fréquence dans un plan perpendiculaire à la direction du champ $\overrightarrow{Bo}$ précédent.

Les images sont obtenues en faisant résonner les noyaux d'hydrogène ou protons, contenus dans les tissus biologiques. Cette résonance est possible parce que chaque proton se comporte comme un microscopique aimant. En effet, lorsque l'on applique le champ statique $\overrightarrow{Bo}$ , les spins nucléaires s'orientent tous de telle sorte que la résultante macroscopique de leurs moments magnétiques soit située parallèlement à l'axe du champ. Lorsqu'on applique en plus le champ tournant à une fréquence quelconque, il ne se passe rien. Mais si cette fréquence est choisie égale ou très voisine de $f_o$, telle que $f_o = \gamma B_o$, formule dans laquelle $\gamma$ est une constante physique caractéristique des noyaux que l'on veut mettre en résonance, le couplage des spins et du champ tournant atteint une valeur telle que ceux-ci entrent en résonance.

Le signal de résonance détecté est proportionnel à l'aimantation des noyaux placés dans le champ magnétique $\overrightarrow{Bo}$ de polarisation. L'observation du phénomène de résonance requiert donc la présence d'un champ magnétique élevé (de quelques 0.1 à quelques teslas) et de très grande uniformité dans tout le volume à imager.

L'image de résonance magnétique proprement dite est ensuite construite progressivement à l'aide d'un ordinateur. Pour ce faire, plusieurs méthodes connues existent, notamment de constructions de l'image par points, par lignes et par plans, sur le détail desquelles il n'est pas nécessaire de revenir ici ; il suffira de savoir, pour la compréhension du présent texte, qu'elles impliquent toutes la superposition au champ de polarisation $\overrightarrow{Bo}$ et successivement dans le temps de plusieurs champs gi avec i = x, y, z de durées et d'amplitudes très faibles. L'espace étant ramené à un repère cartésien (x, y et z), chacun de ces champs présente une composante Bzi telle que Gi = ∂Bzi/∂i (Gx = ∂Bzx/∂x, Gy = ∂Bzy/∂y et Gz = ∂Bzz/∂z) soit constant selon i, z étant la direction du champ $\overrightarrow{Bo}$ . On appelle alors B la résultante magnétique B = Bo + gi. L'antenne et l'électronique associées pour la réception des différents signaux de résonance des protons ont une bande passante suffisamment large pour recevoir les fréquences de résonance f, voisine de $f_o$, correspondant en chaque point examine à la valeur $f = \gamma B$, B étant le module du champ résultant en ce point.

A titre indicatif, le champ Bo a par exemple une valeur de 0,05 à 1 tesla et les gradients ∂Bzx/∂x, ∂Bzy/∂y et ∂Bzz/∂z ont un ordre de grandeur de $10^{-2}$ à $10^{-3}$ tesla/mètre sur une longueur moyenne de ± 20 cm environ.

Le champ magnétique $\overrightarrow{Bo}$ peut être créé par des aimants permanents ; la présence d'un circuit magnétique oblige à loger le patient dans un tunnel défini par l'entrefer de l'aimant, et l'induction de polarisation $\overrightarrow{Bo}$ traverse alors généralement le corps du patient de la poitrine vers le dos.

Les dispositifs de production de champs magnétiques à gradient constant constituent une partie très importante d'un imageur et conditionnent sa structure puisque :

1) -de la qualité des gradients dépend la qualité de l'image, toute altération du gradient entraînant une distorsion de celle-ci,

2) -les dispositifs doivent être placés aussi près que possible de l'objet à imager selon des conditions de linéarité impérieuses (à 2 % près dans tout le volume à imager) afin de limiter l'entrefer de l'aimant et par suite le poids donc le coût de la machine, et ce, dans des configurations spatiales telles qu'elles permettent le passage du patient dans ledit entrefer,

3) -le mode de production des champs à gradient constant doit s'intégrer le mieux possible à la structure du circuit magnétique pour limiter la puissance de commutation des alimentations du dispositif en courant pulsé, qui peut atteindre quelques dizaines de kVA,

4) -les champs à gradient constant doivent être établis à chaque mesure dans des temps relativement courts, inférieurs à 1 ms.

Dans de nombreux imageurs RMN, les dispositifs pour créer les gradients sont constitués de bobines montées sur des cylindres entourant le patient.

Cette manière de faire est difficilement adaptable au cas d'un imageur à aimants permanents tel que celui décrit dans la demande de brevet français n° 87 02851 du 3 Mars 1987, par exemple. En effet, ce dernier est constitué d'un système de deux aimants principaux de même direction d'aimantation et parallèles. Les faces en regard de ces aimants sont recouvertes chacune d'une pièce polaire délimitant l'entrefer de l'aimant. Les parois latérales sont fermées par deux aimants, le tout étant maintenu dans une carcasse métallique permettant la fermeture des lignes de champ, ce champ $\vec{Bo}$ étant créé par l'ensemble de ces aimants. Dans un tel système, le tunnel dans lequel est introduit le patient est un parallélépipède rectangle.

La création des gradients par des bobines cylindriques implique un placement de ces dernières relativement lointain des pièces polaires, ce qui conduit à une diminution inacceptable de la place réservée dans l'entrefer au corps du patient.

On connaît un autre type de système de bobines pour la création de gradients : celui décrit dans la demande de brevet français n° 84 15301 du 5 Octobre 1984. Dans cette réalisation, les pièces polaires sont en quelque sorte emmaillotées dans deux nappes d'enroulements orthogonales permettant la création des gradients $\partial Bzx/\partial x$ et $\partial Bzy/\partial y$. Ce type de montage présente deux inconvénients majeurs : l'homogénéité du champ magnétique permanent $\vec{Bo}$ est altérée par l'existence d'un jeu entre les aimants latéraux et les pièces polaires et l'impossibilité de retirer le circuit des gradients en cas de panne (court-circuit, coupure d'un conducteur, ...).

Le but de la présente invention est de pallier ces inconvénients en préconisant l'emploi d'un dispositif où la circuiterie est supportée par un support isolant et mince ayant une forme épousant les parois du tunnel. Le dispositif se présente donc comme une enveloppe ayant une forme de parallélépipède rectangle qu'on peut introduire ou sortir du tunnel sans peine. La maintenance du dispositif en est grandement facilitée.

De plus, le dispositif n'occupe qu'un faible volume à l'intérieur du tunnel ne portant pas préjudice à l'introduction d'un patient.

La circuiterie permettant de créer les gradients étant proche des pièces polaires, l'efficacité magnétique est accrue grâce à un effet de miroir sur le courant traversant les différents conducteurs.

De manière plus précise, l'invention concerne un dispositif pour la production de champs magnétiques gx, gy, gz possédant respectivement une composante Bzx, Bzy, Bzz selon la direction oz d'un trièdre trirectangle ox, oy, oz de référence, la composante Bzx présentant un gradient constant Gx selon la direction ox, la composante Bzy présentant un gradient constant Gy selon la direction oy, la composante Bzz présentant un gradient constant Gz selon la direction oz.

Ce dispositif comprend :
- un premier support mince, isolant et amagnétique ayant une forme de parallélépipède rectangle,
- pour la création du gradient Gx, supportées par le premier support, des pistes conductrices sous forme de bandes régulièrement réparties sur des parois du premier support parallèles au plan xoy et allongées selon l'axe oy, ces pistes étant reliées par des connexions à des pistes conductrices disposées sur des parois du premier support parallèles au plan xoz de manière à constituer quatre enroulements connectés entre eux en série de façon à ce qu'un courant électrique se propageant successivement dans chacun de ces enroulements circule dans un même sens dans toutes les pistes disposées sur les parois parallèles au plan xoy,
- un deuxième support mince isolant et amagnétique ayant une forme de parallélépipède rectangle,
- pour la création du gradient Gy, supportées par le deuxième support des pistes conductrices sous forme de bandes régulièrement réparties sur les parois du deuxième support et allongées selon l'axe ox, ces pistes étant reliées entre elles par des connexions de manière à constituer quatre enroulements connectés entre eux en série de manière à ce qu'un courant électrique se propageant successivement dans chacun de ces enroulements circule dans le même sens dans toutes les pistes disposées sur les parois parallèles au plan xoy,
- un troisième support mince, isolant et amagnétique ayant une forme de parallélépipède rectangle et
- pour la création du gradient Gz, supportés par le troisième support, reposant sur des parois du troisième support parallèles au plan xoy, deux bobinages plats à spires rectangulaires allongées selon l'axe ox et connectés l'un à l'autre en série, chaque bobinage reposant sur une paroi distincte, ces bobinages étant identiques et réalisés de manière à ce qu'un courant les parcourant circule en des sens opposés dans chacun d'eux, les premier, deuxième et troisième supports étant emboîtés les uns dans les autres et les enroulements et bobinages pour la création des différents gradients Gx, Gy et Gz étant isolés entre eux.

On entend par support, mince, un support de quelques mm d'épaisseur.

Pour créer les gradients Gx = $\partial Bzx/\partial x$ et Gy = $\partial Bzy/\partial y$ un courant parcourt deux types d'enroulements perpendiculaires entre eux : pour créer le gradient Gx, des enroulements allongés suivant l'axe oy, pour créer le gradient Gy, des enroulements allongés suivant l'axe ox. Les systèmes de création des gradients Gx, Gy présentent une structure quadripolaire : ils sont constitués chacun de quatre enroulements connectés entre eux en série de manière à ce qu'un courant les traversant successivement parcourt les pistes supportées par les parois parallèles au plan xoy et allongées selon oy ou ox pour Gx et Gy, respectivement. Pour chaque circuit dans les deux plans xoy, le courant circule dans le même sens.

Selon un mode avantageux de réalisation de l'invention, les premier et deuxième supports sont constitués respectivement par les surfaces extérieure et intérieure ou les surfaces intérieure et extérieure d'un support unique.

Selon un mode particulier de réalisation, les bobinages pour la création du gradient Gz sont supportés par la surface extérieure du troisième support. Bien entendu, ils peuvent être supportés aussi par la surface intérieure du troisième support.

Les différents supports du dispositif de l'invention s'emboîtent indifféremment les uns dans les autres. Le dispositif se présente comme une enveloppe de forme parallélépipèdique. Ainsi par exemple le premier et le deuxième supports constituent un support unique supportant la circuiterie pour créer les gradients Gx et Gy, et s'emboîtant dans le support supportant la circuiterie qui crée le gradient Gz. Toutes les circuiteries sont isolées les unes des autres.

Dans une forme particulière de réalisation, chaque bobinage pour la création du gradient Gz est formé d'au moins une spire rectangulaire intérieure reliée à des spires rectangulaires bordant les extrémités de la paroi du troisième support parallèle au plan xoy supportant ledit bobinage, chaque spire intérieure comprenant deux pistes conductrices parallèles sous forme de bandes allongées selon l'axe ox, ces pistes étant séparées par un intervalle, ces pistes étant aptes à glisser sur des pistes conductrices parallèles à l'axe oy et situées aux extrémités de ces pistes selon l'axe ox de manière à rendre réglable à volonté l'intervalle séparant les pistes selon l'axe ox.

De cette manière, on peut ajuster mécaniquement les cotes des spires intérieures de façon à optimiser la zone de champ linéaire dans le tunnel et tenir compte des effets perturbateurs de l'environnement sur l'induction magnétique.

Selon un mode de mise en oeuvre de l'invention, chaque bobinage pour la création du gradient Gz, est relié à un ensemble de spires rectangulaires allongées selon l'axe ox et disposées sur la face des parois parallèles au plan xoy du troisième support ne supportant pas lesdits bobinages, ces spires bordant les extrémités de ces parois, ces ensembles de spires étant reliés aux spires des bobinages partageant la même paroi de façon à ce qu'un courant parcourant un bobinage dans un sens circule dans l'ensemble de spires correspondant dans le même sens, ces ensembles de spires contribuant à la création du gradient Gz.

Autrement dit, selon un mode de mise en oeuvre de l'invention chaque bobinage pour la création du gradient Gz disposé sur une paroi du troisième support parallèle au plan xoy peut être réparti sur les deux faces de celles-ci, le sens de circulation du courant n'étant en aucun cas modifié.

Cela peut permettre de concentrer le courant dans une zone du tunnel d'un imageur RMN afin d'améliorer la linéarité du champ créé.

De toute façon, les caractéristiques et avantages de l'invention apparaîtront mieux après la description qui suit donnée à titre explicatif et nullement limitatif. Cette description se réfère à des dessins annexés sur lesquels :

- la figure 1 représente schématiquement une vue de face en perspective d'un dispositif conforme à l'invention,

- la figure 2 représente schématiquement un développé de la face intérieure du premier support d'un dispositif conforme à l'invention,

- la figure 3 représente schématiquement un développé de la face extérieure du premier support d'un dispositif conforme à l'invention,

- la figure 4 représente schématiquement un développé des faces intérieure et extérieure du second support d'un dispositif conforme à l'invention.

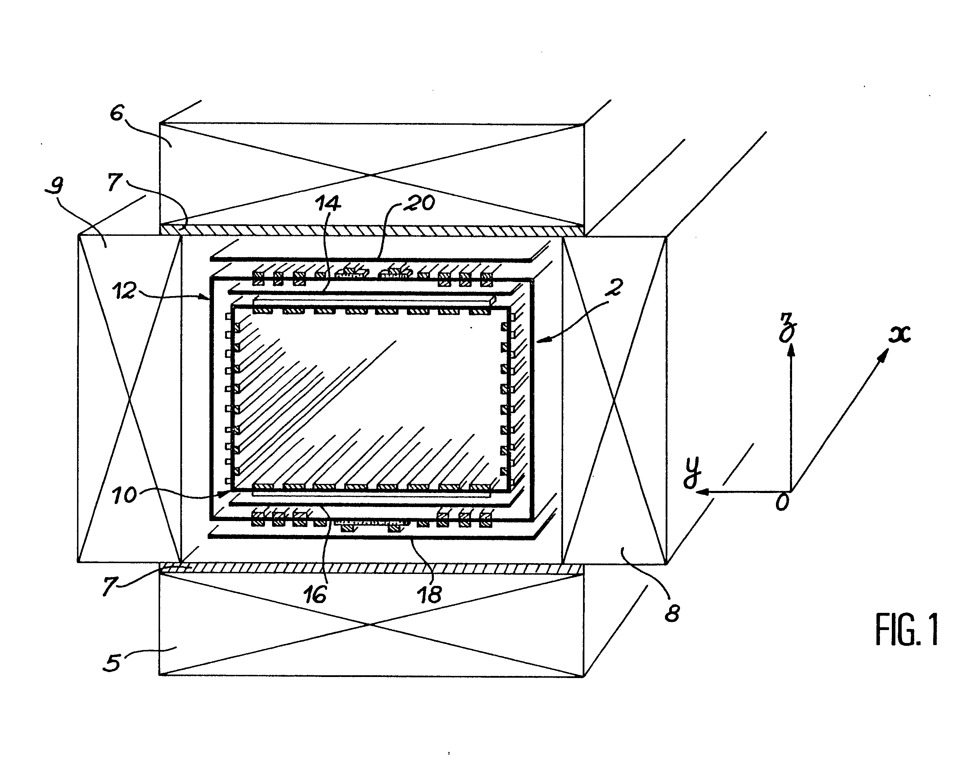

La figure 1 représente schématiquement une vue de face en perspective d'un dispositif conforme à l'invention. Le dispositif 2 est contenu dans un système d'aimants d'un imageur RMN. Ce système est du type de celui décrit dans la demande de brevet français n° 87 02851 du 3 Mars 1987. Il comprend deux aimants permanents principaux 5, 6 de même sens d'aimantation. Les faces en regard de ces aimants 5, 6 supportent des pièces polaires 7 qui délimitent l'entrefer de l'aimant. Deux aimants secondaires 8, 9 ferment les parois latérales de manière à constituer un tunnel dans lequel est introduit le patient.

Un imageur RMN contient bien d'autres éléments non représentés et dont la description n'est pas nécessaire à la compréhension de la présente invention.

Le tunnel de l'imageur a la forme d'un parallélépipède rectangle dont la largeur s'étend le long de l'axe oy d'un trièdre trirectangle de référence, la longueur s'étend le long de l'axe ox et la hauteur s'étend le long de l'axe oz. L'axe ox correspond à la direction d'introduction du patient.

Le dispositif 2 conforme à l'invention a aussi une forme de parallélépipède rectangle : il peut ainsi s'encastrer dans le tunnel.

On voit sur la figure 1 que le dispositif comprend un premier support mince, isolant et amagnétique 10 supportant sur ses faces extérieures et intérieures les circuiteries permettant la création des gradients Gx et Gy respectivement. Un second support mince, isolant et amagnétique 12 supporte la circuiterie permettant la création du gradient Gz. Cette dernière est isolée de la circuiterie permettant la création de Gx par deux feuilles minces, isolantes et amagnétiques 14, 16 disposées entre les premier et second supports 10, 12 parallèlement au plan xoy.

La circuiterie permettant la création de Gz est aussi isolée des pièces polaires 7 par deux feuilles minces, isolantes et amagnétiques 18, 20.

L'isolation des différentes circuiteries peut être aussi réalisée par un dépôt de matériau isolant sur les faces des différents supports sur lesquelles sont disposées les circuiteries.

Les différentes circuiteries permettant la création des gradients Gx, Gy, Gz sont raccordées à une source d'alimentation (non représentée) électrique délivrant des courants impulsionnels adéquats.

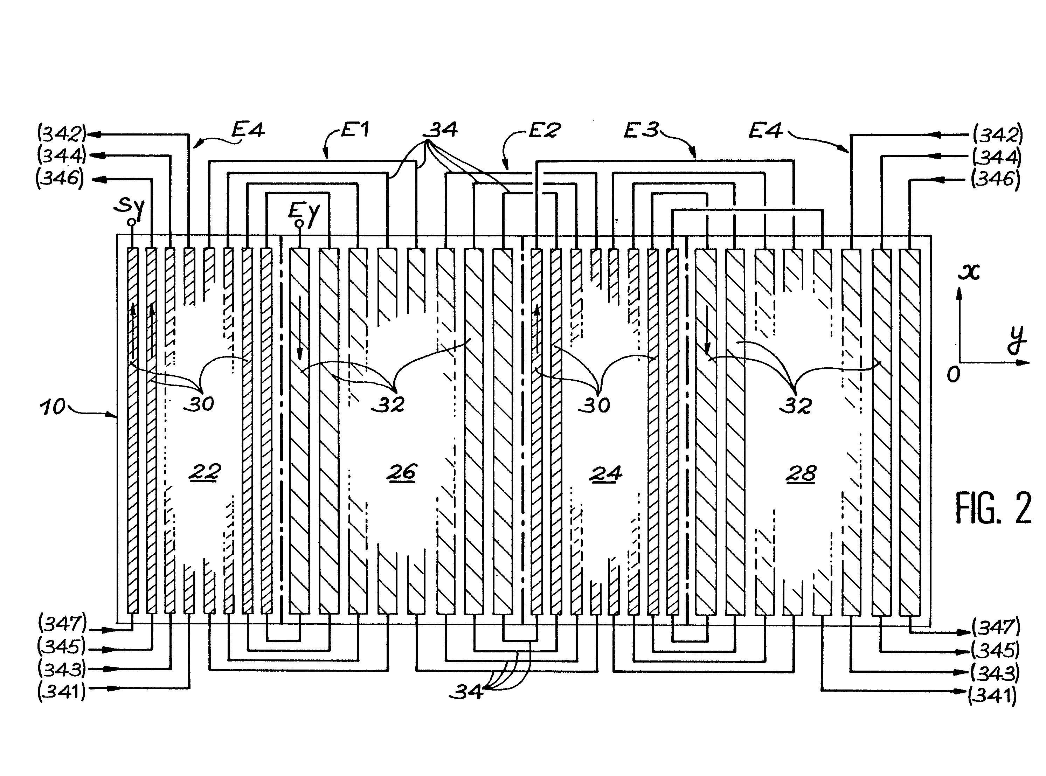

Les figures 2, 3 et 4 représentent schématiquement un exemple des différentes circuiteries permettant la création des gradients Gx, Gy, Gz.

La figure 2 représente schématiquement un développé de la face intérieure du premier support d'un dispositif conforme à l'invention. Le support 10 comporte quatre parois 22, 24, 26, 28 : les parois 22, 24 sont les parois latérales du parallélépipède et sont parallèles au plan xoz du trièdre de référence de la figure 1 les parois 26, 28 sont parallèles au plan xoy.

Cette face intérieure supporte la circuiterie pour la création du gradient Gy. Cette circuiterie comporte des pistes conductrices 30, 32 sous forme de bandes allongées selon l'axe ox. Ces pistes 30, 32 sont régulièrement réparties sur les parois 22, 24, 26, 28.

Les pistes 30 et 32 sont du type de celles des circuits imprimés, par exemple. Elles présentent une épaisseur suffisante pour guider le courant sans créer d'échauffement.

Les pistes 32 reposent sur les parois 26 et 28 parallèles au plan xoy dans le parallélépipède. Les pistes 30 reposent sur les parois 22 et 24 parallèles au plan xoz dans le parallélépipède.

Les pistes 30 et 32 sont reliées entre elles par des connexions 34 de manière à constituer quatre enroulements E1, E2, E3, E4, connectés entre eux en série. De cette façon un courant électrique délivré par une source d'alimentation (non représentée) sur l'entrée Ey se propage successivement dans chacun des enroulements E1, E2, E3, E4. Ce courant circule dans le même sens (indiqué par des flèches sur la figure) dans toutes les pistes 32 disposées sur les parois 26, 28 parallèles au plan xoy du parallélépipède, le retour s'effectuant par les pistes 30 et les connexions 34. Le courant s'évacue ensuite par la sortie Sy. Dans le parallélépipède formé par le support 10, les extrémités des parois 22 et 28 sont jointives. Les références 341 à 347 indiquent la continuité des connexions 34 reliant les pistes 32 situées sur la paroi 28 aux pistes 30 situées sur la paroi 22.

Dans cet exemple de réalisation, huit pistes 30 et 32 sont représentées sur chaque paroi 22, 24, 26, 28. Le nombre de pistes 30, 32 leur largeur et leur épaisseur sont fonction de la hauteur et de la largeur du support, qui sont elles-mêmes fonction du gabarit du tunnel et de l'encombrement des autres éléments de l'imageur présents dans le tunnel. Ces paramètres, nombre, largeur, épaisseur des pistes sont aussi fonction de l'amplitude désirée du champ magnétique à créer (plus le nombre de pistes est élevé, plus cette amplitude est grande) mais aussi du temps de montée désiré de l'impulsion magnétique (par exemple celle-ci est d'autant plus grande que le nombre de pistes est élevé).

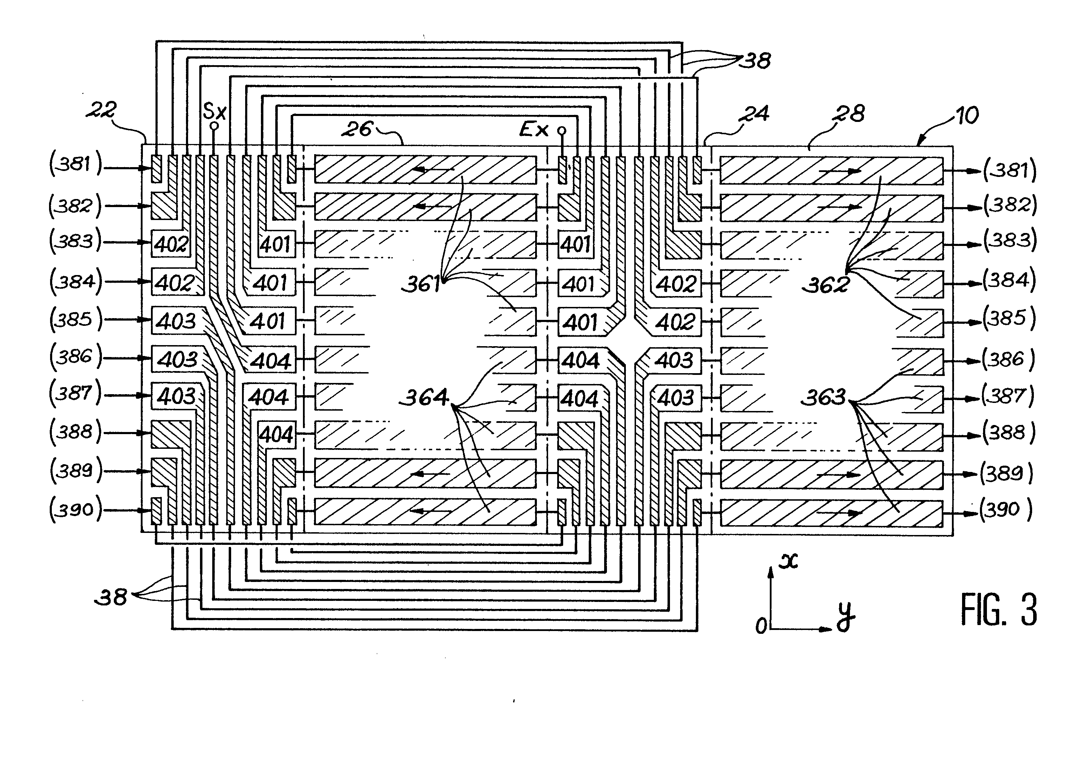

La figure 3 représente schématiquement un développé de la face extérieure du premier support d'un dispositif conforme à l'invention. On voit donc les quatre parois 22, 24, 26, 28 du support 10.

La face extérieure supporte la circuiterie pour la création du gradient Gx. Cette circuiterie comporte des pistes conductrices 361, 362, 363, 364 sous forme de bandes allongées selon l'axe oy. Ces pistes 361, 362, 363, 364 sont régulièrement réparties sur les parois 26 et 28 du support 10, c'est-à-dire les parois parallèles au plan xoy conformément aux références prises sur la figure 1.

En fait, la circuiterie pour la création du gradient Gx réalise une structure quadripolaire composée de quatre enroulements connectés entre eux en série et reliés par l'entrée Ex à une source d'alimentation (non représentée) fournissant un courant adéquat à la formation du champ magnétique désiré. Pour ce faire, les pistes 361, 362, 363, 364 sont reliées respectivement par des connexions 38 à des pistes conductrices 401, 402, 403, 404 situées sur les parois 22 et 24 pour former respectivement les premier, second, troisième et quatrième enroulements.

Les références 381 à 390 indiquent la continuité des connexions 38 reliant les pistes 362 et 363 aux pistes 402 et 403.

Ces enroulements sont tels qu'un courant électrique introduit par l'entrée Ex parcourt successivement les quatre enroulements, et circule dans le même sens dans chacune des pistes 361, 362, 363, 364.

Les flèches représentées sur la figure 3 symbolisent le sens de circulation du courant.

Dans l'exemple de réalisation représenté sur la figure 3, les pistes 401, 402, 403, 404 ont l'allure de bandes allongées selon l'axe ox et présentant une extrémité large, repliée à 90° pour être en regard de l'extrémité d'une piste portée sur l'une des parois parallèles au plan xoy. Ces pistes 401, 402, 403, 404 ont donc dans cet exemple sensiblement l'allure de L encastrés les uns dans les autres ; seules les huit pistes situées dans les coins des parois 22 et 24 ne sont que des bandes allongées selon l'axe ox. Les enroulements représentés sur la figure 3 ne comportent que cinq spires, mais ici encore le nombre de spires de chaque enroulement, c'est-à-dire finalement le nombre de pistes ainsi que leur largeur et leur épaisseur sont fonction des mêmes paramètres que précédemment (temps de montée, amplitude du champ, gabarit du tunnel, ...), ils dépendent donc de chaque utilisation particulière.

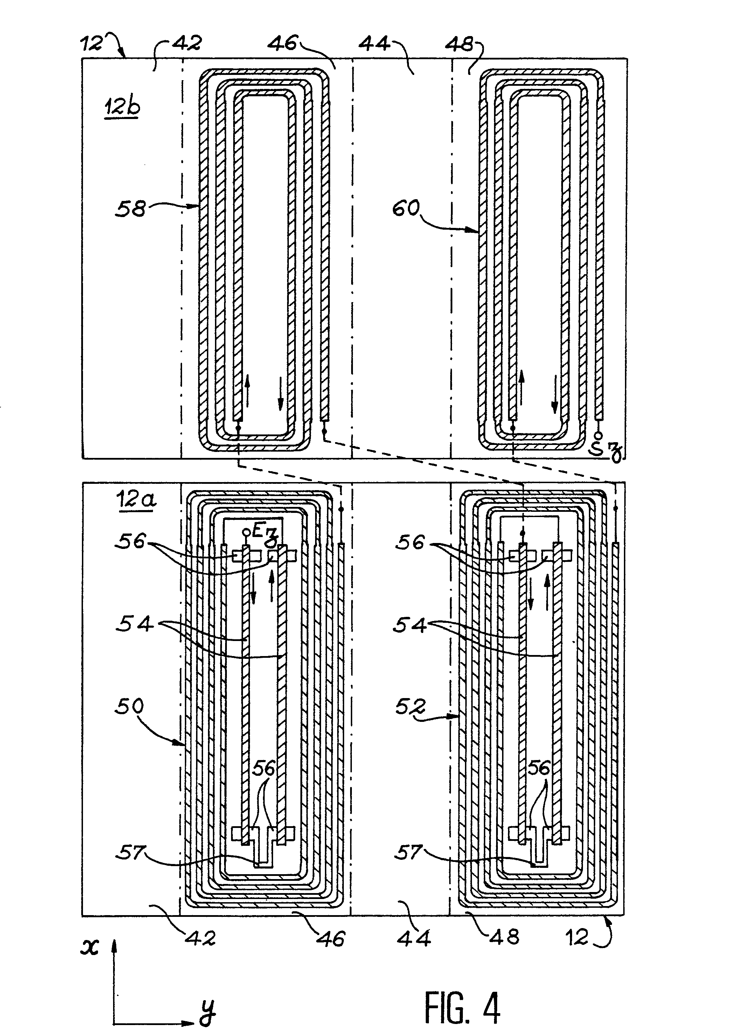

La figure 4 représente schématiquement la circuiterie permettant la création du gradient Gz. Cette circuiterie occupe les faces extérieure 12a et intérieure 12b du second support 12. Elle est isolée de la circuiterie pour la création du gradient Gx par deux feuilles isolantes et amagnétiques 14 et 16 (figure 1). Le second support 12 comporte quatre parois 42, 44, 46, 48. Deux bobinages plats 50, 52 à spires rectangulaires allongées selon l'axe ox reposent sur la face extérieure 12a des parois 46 et 48 parallèles au plan xoy du triédre de référence de la figure 1. Ces bobinages sont identiques : ils comprennent ici une seule spire intérieure reliée à des spires bordant les extrémités des parois 46 et 48. Cette spire intérieure comprend deux pistes 54 parallèles allongées selon l'axe ox et aptes à glisser sur des pistes conductrices 56 parallèles à l'axe oy et situées aux extrémités des pistes selon l'axe ox de manière à rendre réglable à volonté l'intervalle séparant les pistes 54.

Ainsi, on peut ajuster la linéarité du champ dans le tunnel et l'adapter à diverses applications. Cet ajustement étant effectué, les pistes 54 sont maintenues en position par exemple par soudure ou collage à l'aide d'une colle conductrice.

Pour chaque spire intérieure, deux des pistes conductrices 56 sont réunies par une piste conductrice 57 en forme de U afin de fermer la spire.

Les spires rectangulaires des bobinages 50, 52 sont réalisées par des pistes conductrices du type des pistes de circuits imprimés, par exemple.

Sur la face intérieure 12b du second support 12, les parois 46 et 48 supportent chacune un ensemble de spires 58, 60 rectangulaires allongées selon l'axe ox et bordant les extrémités de ces parois 46, 48.

L'ensemble de spires 58 reposant sur la paroi 46 est relié en série avec le bobinage 50 de manière à ce qu'un courant délivré par une source d'alimentation (non représentée) sur l'entrée Ez du bobinage 50 circule dans le même sens dans les spires disposées sur la face externe 12a et dans les spires disposées sur la face interne 12b.

L'ensemble de spires 58 est aussi relié en série avec les spires du bobinage 52 disposé sur la paroi 48 du côté de la face externe 12a. Ces dernières sont connectées en série avec l'ensemble de spires 60. Le courant délivré sur l'entrée Ez parcourt les spires 50, 58 disposées sur la paroi 46 puis circule en un sens opposé dans les spires 52, 60 disposées sur la paroi 48. Le courant circule dans le même sens dans les spires situées sur une même paroi. Le courant est ensuite évacué par la sortie Sz.

Les spires des ensembles 58 et 60 sont réalisées par des pistes conductrices du type par exemple de celles des circuits imprimés.

Cette fois encore la largeur, l'épaisseur des spires et leur nombre dépendent de chaque application particulière.

Le dispositif selon l'invention permet donc bien de créer des gradients Gx = $\partial Bzx/\partial x$, Gy = $\partial Bzy/\partial y$ et Gz = $\partial Bzz/\partial z$. Il s'adapte parfaitement à un tunnel d'imageur RMN de forme parallélépipèdique. Réalisé uniquement avec des éléments minces, les trois circuits étant réunis par un assemblage, son encombrement est faible. De plus, grâce à sa grande maniabilité, son introduction et son extraction sont aisées et la maintenance facilitée. Son efficacité est accrue grâce à un effet de miroir sur le courant dû à la proximité des pièces polaires.

Il va de soi que l'invention ne se limite aucunement à l'exemple de réalisation plus particulièrement décrit et représenté. Dans cet exemple, les circuiteries permettant la création des gradients est complétement intérieure au tunnel de l'imageur mais ces circuiteries peuvent aussi déborder de ce tunnel.

## Revendications

1. Dispositif pour la production de champs magnétiques gx, gy, gz possédant respectivement une composante Bzx, Bzy, Bzz selon la direction oz d'un triédre trirectangle ox, oy, oz de référence, la composante Bzx présentant un gradient constant Gx selon la direction ox, la composante Bzy présentant un gradient constant Gy selon la direction oy, la composante Bzz présentant un gradient constant Gz selon la direction oz, caractérisé en ce qu'il comprend :
- un premier support mince, isolant et amagnétique ayant une forme de parallélépipède rectangle,
- pour la création du gradient Gx, supportées par le premier support, des pistes conductrices (361, 362, 363, 364) sous forme de bandes régulièrement réparties sur des parois (26, 28) du premier support parallèles au plan xoy et allongées selon l'axe oy, ces pistes (361, 362, 363, 364) étant reliées par des connexions (38) à des pistes conductrices (401, 402, 403, 404) disposées sur des parois (22, 24) du premier support parallèles au plan xoz de manière à constituer quatre enroulements connectés entre eux en série de façon à ce qu'un courant électrique se propageant successivement dans chacun de ces enroulements circule dans un même sens dans toutes les pistes (361, 362, 363, 364) disposées sur les parois (26, 28) parallèles au plan xoy,

- un deuxième support mince isolant et amagnétique ayant une forme de parallélépipède rectangle,

- pour la création du gradient Gy, supportées par le deuxième support des pistes conductrices (30, 32) sous forme de bandes régulièrement réparties sur les parois du deuxième support et allongées selon l'axe ox, ces pistes (30, 32) étant reliées entre elles par des connexions (34) de manière à constituer quatre enroulements (E1, E2, E3, E4) connectés entre eux en série de manière à ce qu'un courant électrique se propageant successivement dans chacun de ces enroulements (E1, E2, E3, E4) circule dans le même sens dans toutes les pistes (32) disposées sur les parois parallèles au plan xoy,

- un troisième support mince, isolant et amagnétique ayant une forme de parallélépipède rectangle et

- pour la création du gradient Gz, supportés par le troisième support, reposant sur des parois (46, 48) du troisième support parallèles au plan xoy, deux bobinages plats (50, 52) à spires rectangulaires allongées selon l'axe ox et connectés l'un à l'autre en série, chaque bobinage (50, 52) reposant sur une paroi distincte, ces bobinages (50, 52) étant identiques et réalisés de manière à ce qu'un courant les parcourant circule en des sens opposés dans chacun d'eux, les premier, deuxième et troisième supports étant emboîtés les uns dans les autres et les enroulements et bobinages pour la création des différents gradients Gx, Gy et Gz étant isolés entre eux.

2. Dispositif selon la revendication 1, caractérisé en ce que : les premier et deuxième supports sont constitués respectivement par les surfaces extérieure et intérieure ou les surfaces intérieure et extérieure d'un support unique (10).

3. Dispositif selon la revendication 1, caractérisé en ce que chaque bobinage (50, 52) pour la création du gradient Gz est formé d'au moins une spire rectangulaire intérieure reliée à des spires rectangulaires bordant les extrémités de la paroi du troisième support parallèle au plan xoy supportant ledit bobinage, chaque spire intérieure comprenant deux pistes conductrices (54) parallèles sous forme de bandes allongées selon l'axe ox, ces pistes (54) étant séparées par un intervalle, ces pistes (54) étant aptes à glisser sur des pistes conductrices (56) parallèles à l'axe oy et situées aux extrémités de ces pistes (54) selon l'axe ox de manière à rendre réglable à volonté l'intervalle séparant les pistes (54) selon l'axe ox.

4. Dispositif selon la revendication 1, caractérisé en ce que chaque bobinage (50, 52) pour la création du gradient Gz, est relié à un ensemble (58, 60) de spires rectangulaires allongées selon l'axe ox et disposées sur la face des parois parallèles au plan xoy du troisième support ne supportant pas lesdits bobinages, ces spires bordant les extrémités de ces parois, ces ensembles de spires étant reliés aux spires des bobinages (50, 52) partageant la même paroi de façon à ce qu'un courant parcourant un bobinage dans un sens circule dans l'ensemble de spires correspondant dans le même sens; ces ensembles de spires (58, 60) contribuant à la création du gradient Gz.

FIG.1

EP 0 397 574 A1

FIG. 2

EP 0 397 574 A1

FIG. 3

EP 0 397 574 A1

FIG. 4

Office européen
des brevets

**RAPPORT DE RECHERCHE EUROPEENNE**

Numero de la demande

EP 90 40 1246

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 217 520 (RESONEX, INC.) <br> * Colonne 3, ligne 3 - colonne 4, ligne 39; figures 1-4 * | 1 | G 01 R 33/38 |
| A | JOURNAL OF PHYSICS E: SCIENTIFIC INSTRUMENTS, vol. 21, no. 6, juin 1988, pages 565-568, IOP Publishing Ltd, Bristol, GB; F. MOMO et al.: "Generalised Anderson coils for magnetic resonance imaging" <br> * Sections 1,2; figures 1,6 * | 1 | |
| A | EP-A-0 178 216 (COMMISSARIAT A L'ENERGIE ATOMIQUE, ETABLISSEMENT DE CARACTERE SCIENTIFIQUE TECHNIQUE ET INDUSTRIEL) <br> * Colonne 7, ligne 60 - colonne 8, ligne 27; colonne 10, lignes 24-39; figures 2,3,6,7 * & FR-A-2 571 496 (Cat. A,D) | 1 | |
| A | WO-A-8 903 031 (CENTRE NATIONAL DE LA RECHERCHE SCIENTIFIQUE) <br> * Page 16, ligne 1 - page 17, ligne 15; figures 2a-3b * | 1 | **DOMAINES TECHNIQUES RECHERCHES (Int. Cl.5)** <br><br> G 01 N <br> G 01 R |
| A | EP-A-0 304 127 (N.V. PHILIPS' GLOEILAMPENFABRIEKEN) <br> * Colonne 5, ligne 8 - colonne 6, ligne 26 * | 1 | |

Le présent rapport a été établi pour toutes les revendications

| Lieu de la recherche | Date d'achèvement de la recherche | Examinateur |
|---|---|---|
| LA HAYE | 28-08-1990 | HORAK G.I. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................................
& : membre de la même famille, document correspondant

EPO FORM 1503 03.82 (P0402)